# EUROPÄISCHE PATENTSCHRIFT

(11) **EP 0 793 112 B1**
(45) Veröffentlichungstag und Bekanntmachung des Hinweises auf die Patenterteilung: **19.01.2000**
(21) Anmeldenummer: 97102528.3
(22) Anmeldetag: 17.02.1997
(51) Int. Cl.: G01R 31/08, G01R 31/12

(54) **Anordnung zur Fehlerortung bei einem gekapselten Rohrleiter und Fehlerortungsverfahren hierzu**
Fault location arrangement in an enclosed rigid line and fault location method therefor
Dispositif de location de faute dans une conduite rigide fermée et procédé de location de faute associé

(30) Priorität: 28.02.1996 DE 19607543
(43) Veröffentlichungstag der Anmeldung: 03.09.1997
(73) Patentinhaber: SIEMENS AKTIENGESELLSCHAFT, 80333 München (DE)
(72) Erfinder: Hillers, Thomas, Dipl.-Ing., 91085 Weisendorf (DE); Hücker, Thomas, Dr., 14624 Dallgow (DE)

(56) Entgegenhaltungen:
- EP-A- 0 400 405
- DE-A- 3 535 544
- DE-A- 4 142 471
- FR-A- 2 719 125
- US-A- 4 972 290

## Beschreibung

Die Erfindung betrifft eine Anordnung zur Fehlerortung bei einem gekapselten Rohrleiter, insbesondere einer elektrischen Energieübertragungsleitung für Hoch- oder Mittelspannung, und ein Fehlerortungsverfahren hierzu.

Zur Ortung eines Kurzschlusses auf einer elektrischen Energieübertragungsleitung ist es bekannt, einen Distanzschutz zu verwenden. Der Distanzschutz mißt die Impedanz der Übertragungsleitung. Bei einem Kurzschluß, z.B. durch einen Störlichtbogen, wird die Impedanz schlagartig reduziert. Das Distanzschutzgerät erkennt die Impedanzerniedrigung und trennt daraufhin die Übertragungsleitung von der Energieversorgung, so daß der Störlichtbogen nicht mehr mit Energie versorgt ist und erlöscht.

Bei modernen digitalen Distanzschutzgeräten kann bei Vorgabe der Leitungsimpedanz pro Längeneinheit auch der Fehlerort berechnet werden. Die Meßgenauigkeit kann dabei bis zu ca. 2 % der Streckenlänge betragen.

Diese Genauigkeit ist bei Freileitungen beispielsweise ausreichend, da die genaue Fehlerstelle bei einer visuellen Kontrolle erkannt werden kann. Bei einem gekapselten Leiter hingegen ist eine einfache optische Kontrolle des Innenraumes nicht möglich.

Aus der DE-OS 35 35 544 ist eine Vorrichtung zur Lokalisierung von internen Fehlerstellen in gasisolierten Leitungen bekannt, bei der entlang der Kapselung für die jeweiligen Rohrabschnitte als Sensor dienende Elektroden vorgesehen sind. Die Elektroden sind mit einer zentralen Verarbeitungseinrichtung verbunden, in der mittels einer Laufzeitauswertung ein Fehlerort bestimmt wird. Hierbei werden große Datenmengen der Verarbeitungseinrichtung zugeführt, wozu viel Speicherplatz erforderlich ist.

Eine abschnittsweise Überwachung einer elektrischen Leitung mit Speicherung der jeweiligen Meßwerte ist aus der DE-OS 41 42 471 bekannt. Aus dem Aufsatz "Dezentrale und zentrale Fehlerortung in Mittelspannungsnetzen", Elektrizitätswirtschaft, 1995, Jahrgang 94, Heft 10, Seiten 565 bis 571, ist die zentrale Anbindung von herkömmlichen Schutzgeraten an einen zentralen Leitrechner bekannt.

Aus der EP 0 466 155 A2 ist ein Fehlerorter für Kabel bekannt, bei dem ein Lichtleiter entlang des Kabels verlegt ist. Über eine ortsabhängige Temperaturerfassung innerhalb des Lichtleiters wird der Fehlerort näher bestimmt.

Der Erfindung liegt die Aufgabe zugrunde, eine Anordnung und ein Fehlerortungsverfahren zur Fehlerortung für einen gekapselten Rohrleiter anzugeben, wobei eine genauere Fehlerortbestimmung mit geringeren Datenmengen als bisher ermöglicht sein soll.

Die Lösung der Aufgabe gelingt erfindungsgemäß mit einer Anordnung zur Fehlerortung bei einem gekapselten Rohrleiter gemäß Anspruch 1. Auf diese Weise ist eine wesentlich genauere Fehlerortbestimmung gegenüber früher gegeben, wobei für die Fehlerortbestimmung Meßgrößen direkt aus der Nähe des Fehlerortes zur Anwendung kommen. Mit der genauen Fehlerortausgabe kann nunmehr von Personal vor Ort der Fehlerort schneller und mit weniger Aufwand als bisher gefunden werden, so daß die sofortige Fehlerbehebung eingeleitet werden kann.

Prinzipiell ist auch aus dem Aufsatz "Schneller Störlichtbogenschutz für Schaltanlagen", Elektrotechnische Zeitschrift. E.T.Z. 105 (1984) Juli, No.13, eine Lichtbogenerkennung mit Sensoren und die logische Verknüpfung verschiedener Verfahren miteinander bekannt. Vorliegend findet dagegen vielmehr eine Aufgabenteilung, nämlich der Auslösung und der eigentlichen Fehlerortung, statt. Dadurch daß die Informationen der Sensoren nur im Kurzschlußfall verwendet werden, kommen nur für den Lichtbogen relevante Meßwerte oder Meßwertverläufe zur Auswertung. Sonstige störungsbedingt oder betriebsmäßig auftretende Meßwerte oder Störpegel führen zu keiner Auswertung.

Die Anordnung kann eine zentralen Verarbeitungseinrichtung umfassen, die mit den Erfassungseinrichtungen verbunden ist und in der die Laufzeitauswertung zur Bestimmung des Fehlerortes erfolgt. Dadurch stehen für die Fehlerortbestimmung alle Meßwerte entlang des Rohrleiters zur Verfügung, die gemeinsam zentral bearbeitet werden können.

Die Speicher können dabei in der zentralen Verarbeitungseinrichtung angeordnet sein. Damit ist ein kompakter Aufbau der gesamten Anordnung möglich. Bevorzugt sind die jeweiligen Speicher jeweils in den jeweiligen Erfassungseinrichtungen angeordnet. Auf diese Weise ist eine dezentrale Vorverarbeitung der Meßwerte gegeben, wodurch der zentrale Aufwand gering gehalten ist.

Mit Vorteil kann das Schutzgerät einen Näherungswert für den Fehlerort erzeugen, wobei zur Fehlerortbestimmung in der zentralen Verarbeitungseinrichtung die Meßwerte oder Meßwertverläufe zumindest einer oder mehrerer Erfassungseinrichtungen verwendet werden, die in einem vorgebbaren Bereich um den Näherungswert liegen. Die Fehlerortbestimmung erfolgt dabei mit einem Minimum an Meßwerten. Dadurch ist auch bei Berücksichtigung einer groben Toleranz des Näherungswertes eine klare Meßwertauswahl gegeben.

Bevorzugt werden nur die für die Fehlerortbestimmung verwendeten Meßwerte von den Erfassungseinrichtungen an die zentrale Verarbeitungseinrichtung übertragen. Damit müssen nur wenige Meßwerte übertragen werden, was zu einer geringen Belastung für die Datenübertragung zur Verarbeitungseinrichtung bei geringer Übertragungsdauer führt.

Die Erfassungseinrichtungen sind vorteilhafterweise über eine Ringleitung mit der zentralen Verarbeitungseinrichtung verbunden. Dadurch ist nur ein geringer Verbindung- oder Verdrahtungsaufwand nötig. Das Schutzgerät kann mit der zentralen Verarbeitungseinrichtung über eine Datenleitung verbunden sein. Dadurch sind auch zusätzliche Informationen übertragbar.

Die Daten- und /oder Ringleitung kann/können als Lichtwellenleiter ausgebildet sein. Damit ist eine hohe Datenübertragungsrate bei kurzer Übertragungszeit möglich. Gegebenenfalls ist auch eine nicht leitungsgebundene Datenübertragung, z.B. über Funk oder Lichtkopplung, denkbar.

Es ist günstig, wenn die gespeicherten Meßwerte in den Speichern mit einem Zeitzeichen versehen oder miteinander synchronisiert sind. Auf diese Weise ist eine exakte Fehlerortbestimmung möglich.

Die jeweiligen Sensoren können zur Erfassung von Druck, Schall, elektromagnetischer Emission oder Lichtemission ausgebildet sein. Dadurch ist für den jeweiligen Anwendungsfall die günstigste Sensorart wählbar. Bevorzugt kommen Schall- oder Lichtsensoren zur Anwendung. Schallsensoren können z.B. zur Aufnahme eines vom Lichtbogen erzeugten Geräusches an der Kapselung oder im Innenraum des Rohrleiters dienen.

Mit Vorteil sind in den Erfassungseinrichtungen den jeweiligen Sensoren jeweils ein Analog-Digital-Wandler nachgeschaltet, wobei die Meßwerte digital in den Speichern geführt sind. Damit ist eine digitale Signalverarbeitung gegeben, die eine Fehlerortbestimmung mit einer hohen Genauigkeit erlaubt und im übrigen die allgemein bekannten Vorteile einer solchen Signalverarbeitung aufweist. Die Erfassungseinrichtungen können dabei auch jeweils einen Rechner, insbesondere einen Mikrocomputer umfassen, wodurch einen schnelle und umfassende Datenverarbeitung der Meßwerte gegeben ist.

Bevorzugt sind die Speicher als Umlaufspeicher oder -puffer ausgebildet. Damit ist nur geringer Speicherplatz nötig, der sich an dem benötigten Zeitfenster, das von der Reaktionszeit der gesamten Anordnung abhängig ist, orientiert.

Bevorzugt ist das Schutzgerät ein Distanzschutz. Insbesondere in Ausbildung als digitales Gerät ist einen gute Einbindung mit allen Datenverbindungen in die Anordnung möglich.

Die Anordnung läßt sich bevorzugt bei einem SF6-isolierten gekapselten Rohrleiter für Hoch- oder Mittelspannung bei langen Leitungslängen anwenden. Hier läßt sich der bisherige Suchaufwand im Fehlerfall besonders gering halten.

Gemäß einer weiteren erfindungsgemäßen Lösung der Aufgabe ist ein Fehlerortungsverfahren für einen Rohrleiter gemäß Anspruch 15 vorgesehen. Dieses Verfahren ist besonders einfach und läßt eine präzisere Fehlerortbestimmung als bisher zu.

Es kann mit der Kurzschlußüberwachung ein Näherungswert für den Fehlerort bestimmt werden. Auf diese Weise liegt ein Vergleichswert vor, der eine Fehlerorteingrenzung zuläßt. Bevorzugt werden zur Laufzeitauswertung nur die Meßwerte der Erfassungsorte in der Nähe des durch den Näherungswertes bestimmten Fehlerortes verwendet. Damit ist eine schnelle Fehlerortbestimmung möglich, die nur wenig Rechenaufwand benötigt. Es erfolgt dadurch eine Meßdatenvorauswahl.

Die Kurzschlußüberwachung erfolgt bevorzugt mittels einer Impedanzüberwachung. Dabei können ohnehin an der Rohrleitung verwendete Geräte benutzt werden. Der Näherungswert kann mit Vorteil aus der berechneten Impedanz ermittelt werden. Der Näherungswert ergibt sich dabei ausgehend von der Impedanz unter Berücksichtigung der Impedanz pro Längeneinheit und dem Erfassungsort des Schutzgerätes.

Die gespeicherten Meßwerte können vorteilhafterweise mit einem Zeitzeichen versehen oder miteinander synchronisiert sein, wodurch eine gemeinsame Basis für die exakte Fehlerortbestimmung gegen ist.

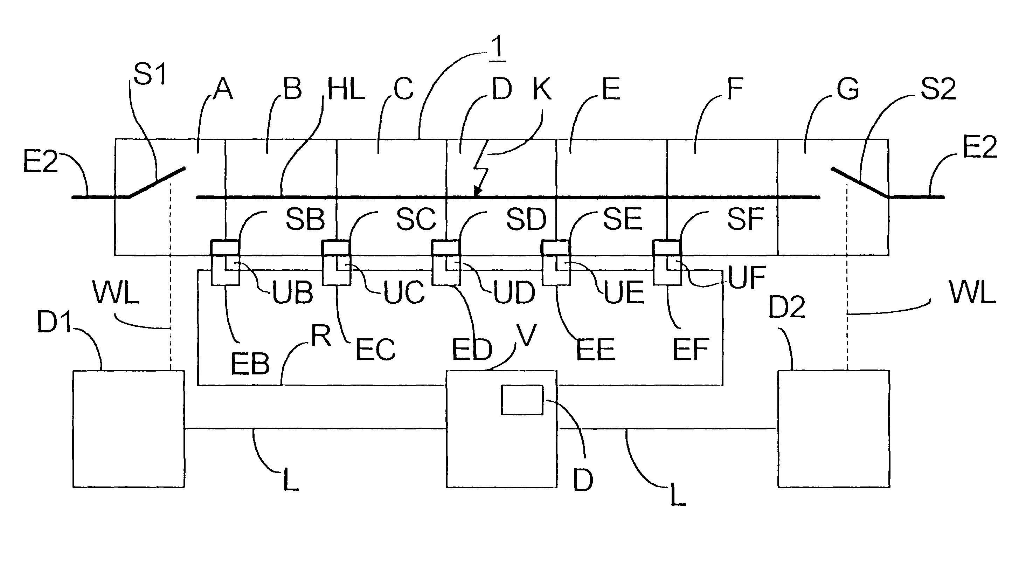

Ein Ausführungsbeispiel der Erfindung, weitere Details und Vorteile werden nachfolgend anhand der Zeichnung näher erläutert.

Die FIG zeigt einen Rohrleiter 1 in einer Prinzipdarstellung, der eine Vielzahl von Rohrleiterabschnitten A bis G umfaßt. Unter dem Begriff "Rohrleiter " wird vorliegend ein elektrischer Leiter verstanden, der von einer rohrförmigen Kapselung umgeben ist Der Leiter an sich kann dabei massiv oder auch hohl nach Art eines Rohres ausgebildet sein. In der Praxis wird ein derartiger Leiter auch als gasisolierte Übertragungsleitung bezeichnet.

Der Rohrleiter 1 weist in seinem Inneren einen Leiter HL auf. Der Rohrleiter 1 dient bevorzugt zur Übertragung elektrischer Energie über lange Strecken mit einer hohen Übertragungsspannung, z.B. Hoch- oder Mittelspannung, wozu sein Innenraum gegebenenfalls mit einem Isoliermedium, z.B. SF6-Gas oder Stickstoff, gefüllt ist. Die einzelnen Rohrleiterabschnitte A bis G können eine Länge bis zu mehreren Kilometern haben und getrennte Gasräume aufweisen, die gegebenenfalls gegeneinander abgeschottet sind.

Die endseitigen Rohrleiterabschnitte A und G weisen beispielhaft Schaltmittel S1 beziehungsweise S2, insbesondere Leistungs- oder Lasttrennschalter, auf, mit denen der Rohrleiter 1 über Endanschlüsse E1 beziehungsweise E2 an nicht weiter gezeigte elektrische Einrichtungen, z.B. einen elektrischen Generator oder ein elektrisches Netz, angeschlossen oder getrennt werden kann. Die Schaltmittel S1, S2 können wahlweise innerhalb oder auch außerhalb, z.B. bei Ausbildung als Freiluftschalter, des Rohrleiters 1 angeordnet sein.

Die von dem Rohrleiter 1 gebildete Übertragungsleitung weist endseitig jeweils einen zugeordneten Distanzschutz D1 bzw. D2 auf, wobei diese Geräte den Rohrleiter 1 auf einen Kurzschluß K (symbolisch dargestellt) von beiden Enden her überwachen. Sie sind dabei über nicht näher gezeigte, allgemein übliche Strom- und Spannungssensoren zur Meßwerterfassung an den Rohrleiter 1 angekoppelt. Für den Fall eines Kurzschlusses erzeugen die Distanzschutzgeräte D1 und D2 jeweils ein sogenanntes Aussignal, das ein Öffnen der Schaltmittel S1 und/ oder S2 bewirkt. Diese Funktion ist durch die Wirklinien WL symbolisiert. Selbstverständlich ist die vorliegende Funktion auch nur mit einem Distanzschutzgerät realisierbar.

Ein derartiges Distanzschutzgerät kann den Fehlerort für den Kurzschluß K ausgehend von einer am Ende der Übertragungsleitung gemessenen Impedanz und der bekannten Leitungsimpedanz auf bis zu ca. 2 % der gesamten Streckenlänge genau bestimmen oder berechnen.

Im Falle einer sehr langen Übertragungsstrecke ist diese Genauigkeit zur direkten Fehlerbehebung ohne weitere Suche des Fehlerortes jedoch nicht hoch genug. Bei beispielsweise einer Gesamtlänge von 20 km könnte der Fehler also in einem Bereich von 400 m mit der bisherigen Genauigkeit liegen. Damit wäre also immer noch ein erheblicher Suchaufwand vor Ort durch Personal nötig.

Hier gilt es den Fehlerort genauer zu ermitteln. Dazu sind entlang des Rohrleiters 1 den jeweiligen Rohrleiterabschnitten A bis G Erfassungseinrichtungen EB bis EF zugeordnet. Es ist günstig, die Erfassungseinrichtungen EA bis EF bei allen Rohrleiterabschnitten A bis G an gleichen Stellen, z.B. am Ende oder in der Mitte, anzuordnen, so daß gleiche Meßvoraussetzungen gegeben sind.

Bevorzugt dient dazu eine Stelle im Trennbereich der Rohrleiterabschnitte A bis G, so daß eine Erfassung einer physikalischen Größe aus jeweils beiden angrenzenden Rohrleiterabschnitten gleichzeitig möglich ist. Gegebenenfalls können auch spezielle Abschnitte, z.B. der Abschnitt G mit dem Schaltmittel S2, von der Überwachung ausgenommen sein.

Die Erfassungseinrichtungen EB bis EF weisen jeweils zumindest einen Sensor SB bis SF auf, der zum Erfassen der jeweils gewünschten physikalischen Größe ausgebildet ist. Als physikalische Größen kommen bevorzugt Druck, Schall, Licht oder eine elektromagnetische Emission, insbesondere eine elektromagnetische Welle, zur Auswertung. Die jeweiligen Sensoren SB bis SF können dabei je nach Art der zu messenden Größe außerhalb des Rohrleiters 1 an seiner äußeren Wandung, innerhalb dieser oder zumindest auf den Innenraum gerichtet angeordnet sein. Dies erfolgt gegebenenfalls nach dem bekannten Möglichkeiten aus dem Stand der Technik.

Jede Erfassungseinrichtung EB bis EF weist zumindest einen Umlaufpuffer UB bis UF als Speicher auf, in dem der jeweils erfaßte Meßwert der physikalischen Größe fortlaufend eingelesen wird. Bevorzugt sind die Erfassungseinrichtungen EA bis EF digital ausgeführt, so daß mittels eines nicht näher gezeigten Analog-Digital-Wandlers, z.B. einem ΣΔ-Wandler, die von den jeweiligen Sensoren SB bis SF gelieferten Meßsignale digitalisiert und dann in den jeweiligen Umlaufpuffern UB bis UF hinterlegt werden. Die jeweiligen analogen Meßwertverläufe liegen somit als digitale Samples vor.

Gegebenenfalls können die Erfassungseinrichtungen EB bis EF hierzu auch einen Rechner, insbesondere einen Mikrocomputer, zur Datenverwaltung und zur sonstigen Organisation der Funktionen umfassen. Alternativ ist selbstverständlich auch eine Ausführung in analoger Technik und/oder eine zentrale Meßwertspeicherung denkbar.

Die Erfassungseinrichtungen EB bis EF sind bevorzugt über eine Ringleitung R mit einer zentralen Verarbeitungseinrichtung V verbunden. Selbstverständlich ist auch eine sternförmige Anbindung der Erfassungseinrichtung EB bis EF denkbar. Die Wahl der jeweils günstigsten Verbindungsart, gegebenenfalls auch eine gemischte Ausführung, erfolgt nach den jeweiligen örtlichen Gegebenheiten und der dadurch entstehenden günstigsten Konfiguration bei geringstmöglichen Verbindungs-, Verdrahtungs- und Kostenaufwand.

Die Verarbeitungseinrichtung V steht über Leitungen L mit den Distanzschutzgeräten D1 und D2 in Verbindung. Die Leitungen L und/oder die Ringleitung R sind bevorzugt als Lichtwellenleiter ausgeführt. Herkömmliche Draht- oder sonstige Busleitungen oder eine drahtlose Informationsübertragung, z.B. über Funk, -auch in gemischter Form- sind ebenfalls möglich.

Zur genauen Ermittlung des Fehlerortes wird folgendermaßen verfahren:

Erkennen die oder zumindest eines der Distanzschutzgeräte D1 und/oder D2 einen Kurzschluß, so wird das jeweilige Aussignal zusätzlich an die Verarbeitungseinrichtung V gesendet oder weitergegeben. Diese sendet in Abhängigkeit hiervon - gegebenenfalls nach einem Auswahlverfahren - ein Steuersignal an die Erfassungseinrichtungen EB bis EF, so daß dort der jeweilige Speicherinhalt der Umlaufpuffer festgehalten wird. Damit ist in jedem Umlaufpuffer UB bis UF ein zeitliches Abbild der physikalischen Größe für den jeweiligen Rohrleiterabschnitt A bis F festgehalten cder hinterlegt.

Nach einer, bevorzugt von der Verarbeitungseinrichtung V gesteuerten, Aufrufroutine werden die digitalen Meßwerte aus den jeweiligen Umlaufpuffern UB bis UF über die Ringleitung R an die Verarbeitungseinrichtung V übertragen. Hierzu können prinzipiell allgemein bekannte Übertragungsmethoden, z.B. aus der Leittechnik bekannte, verwendet werden.

In der Verarbeitungseinrichtung V wird dann ausgehend von der spezifischen Laufzeit der erfaßten Größe im jeweiligen Übertragungsmedium, z.B. der Schallgeschwindigkeit, dem Erfassungsort und den jeweils gespeicherten Meßwertverläufen der Fehlerort auf Basis einer Laufzeitauswertung ermittelt und ausgegeben. Dies erfolgt nach allgemein aus der Mathematik und Physik bekannten Regeln und Formeln.

Es schließt sich dann gegebenenfalls noch ein Vergleich der jeweils ermittelten Entfernungen der Fehlerstelle von verschiedenen Sensoren SB bis SF an. Dies kann zur besseren Feststellung der Lage des Fehlerortes von Vorteil sein, insbesondere wenn er sich in der direkten Nähe eines Sensors befindet.

Die endgültige Fehlerortangabe sollte sich sinnvollerweise auf einen festen Bezugspunkt, z.B. auf den Anfang oder das Ende, des Rohrleiters 1 beziehen. Die Ausgabe des Fehlerortes kann z.B. über ein Display D oder über eine nicht näher dargestellte Schnittstelle erfolgen.

Gegebenenfalls kann auch mit einer gewichteten Betrachtung, z.B. mit einem Fuzzy-Glied, einem Vergleich mehrerer oder aller Meßwertverläufe, oder unter Berücksichtigung von Meßungenauigkeiten eine Erhöhung der Genauigkeit der Fehlerortangabe erzielt werden.

Bei der Laufzeitauswertung muß zunächst von einem gemeinsamen Ereignis ausgegangen werden. Dies ist vorliegend der Zeitpunkt des Eintritts des Fehlers, der von den Distanzsschutzgeräten D1 ,D2 ermittelt wird. Die Zeitinformation hierüber wird sinnvollerweise ebenfalls an die Verarbeitungseinrichtung V übertragen.

Die Zeitkennzeichnung der Meßwerte kann beispielsweise mit dem Steuersignal oder einem periodischen Signal der Verarbeitungseinrichtung V erfolgen. Es ist auch möglich, daß die jeweiligen Erfassungseinrichtungen EB bis EF synchronisierte Uhren, z.B. über DCF-Funkzeichen oder GPS synchronisiert, enthalten, wobei den jeweiligen Meßwerten bei der Speicherung bereits ein Zeitkennzeichen zugeordnet wird.

Als charakteristisches Ereignis für das Ende einer jeweiligen Laufzeit, z.B. eines Schall- oder Lichtsignals, vom Fehlerort zu den jeweiligen Sensoren SB bis SF kann beispielsweise der Anstieg des jeweiligen Meßwertes auf einen bestimmten Wert, z.B. den Scheitelwert, angenommen werden. Wesentlich ist dabei, daß von den jeweiligen Meßwertverläufen immer der gleiche Vergleichswert oder Bezugspunkt für den Laufzeitvergleich verwendet wird. Dabei sind die jeweiligen Meßwerte oder Meßwertverläufe von ihren Erfassungseinrichtungen EB bis EF her derart mit einem Zeitkennzeichen, -Stempel oder einer Zeitinformation versehen, so daß sich die Laufzeit ausgehend vom Zeitpunkt des Fehlereintritts genau ermitteln läßt.

Eine weitere Verbesserung oder Vereinfachung des gesamten Aufwandes kann durch folgende Verfahrensweise erzielt werden:

Die Distanzschutzgeräte D1 und D2 ermitteln aus den ihnen vorliegenden Informationen zunächst den Fehlerort als Näherungswert. Diese Funktion ist bei modernen digitalen Distanzschutzgeräten bereits integriert. Die Fehlerortinformation wird als Näherungswert an die Verarbeitungseinrichtung V übermittelt. Diese wählt dann nach einem vorgegebenen Auswahlverfahren, gegebenenfalls nach gewichteten Gesichtspunkten, die Erfassungseinrichtungen aus, die beispielsweise den geringsten Abstand vom Fehlerort haben. Dies könnten im vorliegenden Fall beispielsweise die Erfassungseinrichtungen ED und EE sein. Nur von diesen ausgewählten Erfassungseinrichtungen ED,EE wird der Speicherinhalt ihrer Umlaufpuffer UD,UE an die Verarbeitungseinrichtung V übertragen. Dazu wird den jeweils ausgewählten Erfassungseinrichtungen ED,EE ein Befehl über die Ringleitung R übermittelt. Die Auswahl der Erfassungseinrichtungen erfolgt zur Reduzierung der zu übertragenden Datenmenge und zur Verringerung der Ermittlungszeit für den Fehlerort.

Die Laufzeitauswertung erfolgt dann auf Basis von nur wenigen, im einfachsten Fall von nur zwei Meßwerten oder Meßwertverläufen. Um auch einen Fehlerort in der Nähe einer Erfassungseinrichtung genau zu ermitteln, kann es günstig sein, die Meßwerte von drei Erfassungseinrichtungen zu verwenden.

Es ist auch denkbar, daß die Erfassungseinrichtungen EB bis EF drahtlos abfragbar sind. Die Sensoren können dabei nach Art von Oberflächenwellensensoren mit Antennen ausgebildet sein, wobei die Informationsübertragung auch innerhalb des Rohrleiters 1 drahtlos erfolgen kann. Die Umlaufpuffer UB bis UF können auch zentral bei oder in der verarbeitungseinrichtung V angeordnet sein oder mit dieser eine Baueinheit bilden.

Wesentlich für die vorliegende Idee ist, daß ausgehen von einer Kurzschlußerkennung mit Hilfe einer Laufzeituntersuchung einer beliebigen erfaßten physikalischen Größe der Fehlerort eines Kurzschlusses im Rohrleiter genau bestimmt werden kann.

## Patentansprüche

1. Anordnung zur Fehlerortung bei einem gekapselten Rohrleiter (1) mit:
- zumindest einem Schutzgerät (D1,D2), das den Rohrleiter (1) auf einen Kurzschluß (K) überwacht und im Fehlerfall ein Aussignal und einen Näherungwert für den Fehlerort erzeugt,
- entlang des Rohrleiters (1) angeordneten Erfassungseinrichtungen (EB bis EF), die zur Erfassung einer physikalischen Größe für einen jeweils zugeordneten Rohrleiterabschnitt (A bis G) jeweils zumindest einen Sensor (SB bis SF) umfassen, der jeweils mit einem Speicher (UB bis UF) verbunden ist, in den fortlaufend Meßwerte der Größe gespeichert werden, und
- einer zentralen Verarbeitungseinrichtung (V) der zur genauen Fehlerortbestimmung zumindest ein Meßwert oder ein Meßwertverlauf zumindest einer der Erfassungseinrichtungen (EB bis EF), die in einem vorgegebenen Abstandsbereich zum Näherungswert des Fehlerortes liegt, zugeführt wird, und in der mittels einer Laufzeitauswertung ein genauer Wert für den Fehlerort des Kurzschlusses (K) erzeugt wird.

2. Anordnung nach Anspruch 1, wobei die Speicher in der zentralen Verarbeitungseinrichtung (V) angeordnet sind.

3. Anordnung nach Anspruch 1, wobei die jeweiligen Speicher (UB bis UF) jeweils in den jeweiligen Erfassungseinrichtungen (EB bis EF) angeordnet sind.

4. Anordnung nach einem der vorhergehenden Ansprüche, wobei nur die für die Fehlerortbestimmung verwendeten Meßwerte oder Meßwertverläufe von den Erfassungseinrichtungen (EB bis EF) an die zentrale Verarbeitungseinrichtung (V) übertragbar sind.

5. Anordnung nach einem der vorhergehenden Ansprüche, wobei die Erfassungseinrichtungen (EB bis EF) über eine Ringleitung (R) mit der zentralen Verarbeitungseinrichtung (V) verbunden sind.

6. Anordnung nach einem der vorhergehenden Ansprüche, wobei das Schutzgerät (D1,D2) mit der zentralen Verarbeitungseinrichtung (V) über eine Datenleitung (L) verbunden ist.

7. Anordnung nach einem der Ansprüche 5 oder 6 ,wobei die Daten- und /oder Ringleitung (L bzw. R) als Lichtwellenleiter ausgebildet ist/sind.

8. Anordnung nach einem der Ansprüche 1 bis 7, wobei die gespeicherten Meßwerte oder Meßwertverläufe in ihren jeweiligen Speichern (UB bis UF) mit einem Zeitzeichen versehen oder miteinander synchronisiert sind.

9. Anordnung nach einem der Ansprüche 1 bis 8, wobei die jeweiligen Sensoren (SB bis SF) zur Erfassung von Druck, Schall, elektromagnetischer Emission oder Lichtemission ausgebildet sind.

10. Anordnung nach einem der Ansprüche 1 bis 9, wobei in den Erfassungseinrichtungen (EB bis EF) den jeweiligen Sensoren (SB bis SF) jeweils ein Analog-Digital-Wandler nachgeschaltet ist und die Meßwerte oder Meßwertverläufe digital in den Speichern (UB bis UF) geführt sind.

11. Anordnung nach einem der Ansprüche 1 bis 10, wobei die Speicher (UB bis UF) als Umlaufpuffer ausgebildet sind.

12. Anordnung nach einem der Ansprüche 1 bis 11, wobei das Schutzgerät (D1,D2) ein Distanzschutz ist.

13. Anordnung nach einem der Ansprüche 1 bis 12, wobei der Rohrleiter (1) ein gasisolierter, insbesondere SF6- und/oder N2-isolierter, gekapselter Rohrleiter für Hoch- oder Mittelspannung ist.

14. Anordnung nach einem der Ansprüche 1 bis 13, wobei an beiden Enden des Rohrleiters (1) ein Schutzgerät (D1,D2) angeordnet ist.

15. Fehlerortungsverfahren für einen Rohrleiter (1), bei dem
- der Rohrleiter (1) endseitig auf einen Kurzschluß (K) überwacht und im Fehlerfall ein Aussignal und ein Näherungswert für den Fehlerort erzeugt werden,
- an mehreren Erfassungsorten entlang des Rohrleiters (1) fortlaufend Meßwerte einer physikalischen Größe im oder am Rohrleiter erfaßt und gespeichert werden, und
- in Abhängigkeit von dem Aussignal auf Basis einer Laufzeitauswertung zumindest eines gespeicherten Meßwertes oder Meßwertverlaufs, der in einem vorgegebenen Bereich vom Näherungswert liegt, ein genauer Wert für den Fehlerort bestimmt und dieser ausgegeben wird.

16. Verfahren nach Anspruch 15, wobei die Kurzschlußüberwachung mittels Impedanzüberwachung erfolgt.

17. Verfahren nach Anspruch 16, wobei der Näherungswert aus der berechneten Impedanz ermittelt wird.

18. Verfahren nach einem der Ansprüche 15 bis 17, wobei die gespeicherten Meßwerte oder Meßwertverläufe mit einem Zeitzeichen versehen oder miteinander syschronisiert sind.

## Claims

1. Arrangement for fault localization in an encapsulated tubular conductor (1), having:
- at least one protective device (D1, D2), which monitors the tubular conductor (1) for a short circuit (K) and generates an off signal and an approximate value for the fault location in the case of a fault,
- detecting devices (EB to EF) which are arranged along the tubular conductor (1) and for the purpose of detecting a physical quantity for a respectively assigned tubular conductor section (A to G) respectively comprise at least one sensor (SB to SF) which is connected in each case to a memory (UB to UF) in which measured values of the quantity are continuously stored, and
to a central processing device (V) to which, for the purpose of accurate determination of a fault location for at least one measured value or a measured value characteristic of one of the detecting devices (EB to EF), which is situated in a prescribed distance range from the approximate value of the fault location, is fed, and in which an exact value is generated for the fault location of the short circuit (K) by means of evaluating propagation delay.

2. Arrangement according to Claim 1, in which the memories are arranged in the central processing device (V).

3. Arrangement according to Claim 1, in which the respective memories (UB to UF) are arranged in each case in the respective detecting devices (EB to EF).

4. Arrangement according to one of the preceding claims, in which only the measured values or measured value characteristics used for the determination of a fault location can be transmitted by the detecting devices (EB to EF) to the central processing device (V).

5. Arrangement according to one of the preceding claims, in which the detecting devices (EB to EF) are connected to the central processing device (V) via a ring circuit (R).

6. Arrangement according to one of the preceding claims, in which the protective device (D1, D2) is connected to the central processing device (V) via a data line (L).

7. Arrangement according to one of Claims 5 or 6, in which the data line and/or ring circuit (L or R respectively) is/are constructed as optical fibres.

8. Arrangement according to one of Claims 1 to 7, in which the stored measured values or measured value characteristics are provided in their respective memories (UB to UF) with a timing mark, or are synchronized with one another.

9. Arrangement according to one of Claims 1 to 8, in which the respective sensors (SB to SF) are designed to detect pressure, sound, electromagnetic emission or light emission.

10. Arrangement according to one of Claims 1 to 9, in which an analog-to-digital converter is respectively connected downstream of the respective sensors (SB to SF) in the detecting devices (EB to EF), and the measured values or measured value characteristics are handled digitally in the memories (UB to UF).

11. Arrangement according to one of Claims 1 to 10, in which the memories (UB to UF) are designed as cyclic buffers.

12. Arrangement according to one of Claims 1 to 11, in which the protective device (D1, D2) is a distance protection.

13. Arrangement according to one of Claims 1 to 12, in which the tubular conductor (1) is a gas-insulated, in particular SF6- and/or N2-insulated, encapsulated tubular conductor for high or medium voltage.

14. Arrangement according to one of Claims 1 to 13, in which a protective device (D1, D2) is arranged at both ends of the tubular conductor (1).

15. Fault localization method for a tubular conductor (1), in which
- the tubular conductor (1) is monitored at the end for a short circuit (K), and in the case of a fault an off signal and an approximate value for the fault location are generated,
- at a plurality of detecting locations along the tubular conductor (1) measured values of a physical quantity are continuously detected in or on the tubular conductor and stored, and
- an exact value is determined for the fault location as a function of the off signal on the basis of evaluation of the propagation delay of at least one stored measured value or measured value characteristic which is situated in a prescribed range from the approximate value, and said exact value is output.

16. Method according to Claim 15, in which the short-circuit monitoring is performed by means of impedance monitoring.

17. Method according to Claim 16, in which the approximate value is determined from the calculated impedance.

18. Method according to one of Claims 15 to 17, in which the stored measured values or measured value characteristics are provided with a timing mark or are synchronized with one another.

## Revendications

1. Dispositif de localisation de défaut dans une conduite blindée (1), comportant :
- au moins un dispositif de protection (D1, D2) qui surveille la conduite (1) pour détecter un court-circuit (K) et qui, en cas de défaut, produit un signal d'arrêt et une valeur approchée pour le lieu de défaut,
- des dispositifs de détection (EB à EF) qui sont disposés le long de la conduite (1) et qui comprennent pour la détection d'une grandeur physique pour un tronçon de conduite (A à G) respectivement associé chacun au moins un capteur (SB à SF) qui est relié à une mémoire (UB à UF) dans laquelle des valeurs mesurées de la grandeur sont mémorisées en continu, et
- un dispositif de traitement (V) central auquel est envoyée pour la localisation de défaut précise au moins une valeur mesurée ou une courbe de valeur mesurée d'au moins l'un des dispositifs de détection (EB à EF) qui se trouvent dans une zone à une certaine distance prescrite par rapport à la valeur approchée du lieu de défaut et dans lequel une valeur précise pour le lieu de défaut du court-circuit (K) est produite au moyen d'une évaluation de temps de propagation.

2. Dispositif selon la revendication 1, dans lequel les mémoires sont agencées dans le dispositif de traitement (V) central.

3. Dispositif selon la revendication 1, dans lequel les mémoires respectives (UB à UF) sont agencées dans les dispositifs de détection (EB à EF) respectifs.

4. Dispositif selon l'une des revendications précédentes, dans lequel seules les valeurs mesurées ou les courbes de valeurs mesurées utilisées pour la localisation de défaut peuvent être transmises par les dispositifs de détection (EB à EF) au dispositif de traitement (V) central.

5. Dispositif selon l'une des revendications précédentes, dans lequel les dispositifs de détection (EB à EF) sont reliés par l'intermédiaire d'une ligne en boucle (R) au dispositif de traitement (V) central.

6. Dispositif selon l'une des revendications précédentes, dans lequel le dispositif de protection (D1, D2) est relié au dispositif de traitement (V) central par l'intermédiaire d'une ligne de données (L).

7. Dispositif selon l'une des revendications 5 ou 6, dans lequel la ligne de données (L) et/ou la ligne en boucle (R) sont conçues sous forme de fibres optiques.

8. Dispositif selon l'une des revendications 1 à 7, dans lequel les valeurs mesurées mémorisées ou les courbes de valeurs mesurées mémorisées dans leurs mémoires respectives (UB à UF) sont munies d'une indication temporelle ou sont synchronisées entre elles.

9. Dispositif selon l'une des revendications 1 à 8, dans lequel les capteurs respectifs (SB à SF) sont conçus pour la détection d'une pression, d'un son, d'une émission électromagnétique ou d'une émission de lumière.

10. Dispositif selon l'une des revendications 1 à 9, dans lequel, dans les dispositifs de détection (EB à EF), un convertisseur analogique-numérique est branché du côté aval de chaque capteur respectif (SB à SF) et les valeurs mesurées ou les courbes de valeurs mesurées sont envoyées sous forme numérique dans les mémoires (UB à UF).

11. Dispositif selon l'une des revendications 1 à 10, dans lequel les mémoires (UB à UF) sont conçues sous forme de tampons circulants.

12. Dispositif selon l'une des revendications 1 à 11, dans lequel le dispositif de protection (D1, D2) est un dispositif de protection à distance.

13. Dispositif selon l'une des revendications 1 à 12, dans lequel la conduite (1) est une conduite blindée, isolée au gaz, notamment isolée au SF6 et/ou isolée au N2, pour haute ou moyenne tension.

14. Dispositif selon l'une des revendications 1 à 13, dans lequel un dispositif de protection (D1, D2) est agencé aux deux extrémités de la conduite (1).

15. Procédé de localisation de défaut pour une conduite (1), dans lequel
- on surveille la conduite (1) par ses extrémités pour détecter un court-circuit (K) et, en cas de défaut, on produit un signal d'arrêt et une valeur approchée pour le lieu de défaut,
- on détecte et mémorise en continu en plusieurs endroits de détection le long de la conduite (1) des valeurs mesurées d'une grandeur physique dans ou sur la conduite (1), et
- en fonction du signal d'arrêt et sur la base d'une évaluation de temps de propagation d'au moins une valeur mesurée mémorisée ou d'au moins une courbe de valeur mesurée mémorisée qui se trouve dans une zone prescrite par rapport à la valeur approchée, on détermine une valeur précise pour le lieu de défaut et on la délivre en sortie.

16. Procédé selon la revendication 15, dans lequel la surveillance de court-circuit s'effectue au moyen d'une surveillance d'impédance.

17. Procédé selon la revendication 16, dans lequel on détermine la valeur approchée à partir de l'impédance calculée.

18. Procédé selon l'une des revendications 15 à 17, dans lequel les valeurs mesurées mémorisées ou les courbes de valeurs mesurées mémorisées sont munies d'une indication temporelle ou sont synchronisées entre elles.
